# EUROPÄISCHE PATENTSCHRIFT

(11) **EP 3 189 543 B1**
(45) Veröffentlichungstag und Bekanntmachung des Hinweises auf die Patenterteilung: **07.02.2024**
(21) Anmeldenummer: 15784274.1
(22) Anmeldetag: 04.09.2015
(51) Int. Cl.: H01L 21/68, G01B 11/27, G01B 11/30

(54) **WAFERAUSRICHTVORRICHTUNG SOWIE VERFAHREN ZUM AUSRICHTEN EINES WAFERS AUF EINE VORBESTIMMTE DREHWINKELLAGE**
WAFER ALIGNING DEVICE AND METHOD FOR ALIGNING A WAFER INTO A SPECIFIED ROTATIONAL ANGULAR POSITION
DISPOSITIF D'ORIENTATION DE TRANCHE ET PROCÉDÉ D'ORIENTATION D'UNE TRANCHE DANS UNE POSITION ANGULAIRE DE ROTATION PRÉDÉFINIE

(30) Priorität: 05.09.2014 DE 102014013188
(43) Veröffentlichungstag der Anmeldung: 12.07.2017
(73) Patentinhaber: MUETEC Automatisierte Mikroskopie und Messtechnik GmbH, 80992 München (DE)
(72) Erfinder: AMMERL, Josef, 94130 Obernzell-Haar (DE)
(74) Vertreter: Paustian, Othmar
(86) Internationale Anmeldenummer: PCT/EP2015/001787
(87) Internationale Veröffentlichungsnummer: WO 2016/034289

(56) Entgegenhaltungen:
- WO-A1-01/40086
- WO-A1-99/45579
- US-A1- 2003 196 343

## Beschreibung

Die vorliegende Erfindung betrifft eine Waferausrichtvorrichtung zur Ablage eines Wafers in einer vorbestimmten Drehwinkellage, ein Wafertransportsystem und eine Waferinspektionsanlage mit einer solchen Waferausrichtvorrichtung sowie ein Verfahren zum Ausrichten des Wafers auf eine vorbestimmte Drehwinkellage und ein Verfahren zum Transport eines Wafers.

Wafer werden inspiziert, um fehlerhafte Wafer zu erkennen, insbesondere während ihrer und/oder im Anschluss an ihre Herstellung. Üblicherweise erfolgt die Inspektion mittels eines Scanners, der die Wafer abtastet. Es sind Inspektionseinrichtungen bekannt, die einen Scanner aufweisen, dem mittels einer Transporteinrichtung ein Wafer zugeführt wird, wobei die Transporteinrichtung einen Waferhalter - auch als Wafertisch oder Chuck bezeichnet - aufweist, in welchem der zu inspizierende Wafer bei der Inspektion platziert ist.

Bei der Inspektion der Wafer ist in einigen bekannten Verfahren das Ergebnis der Inspektion sehr stark von einer Drehwinkelausrichtung des inspizierten Wafers im Waferträger abhängig. Daher werden vielfach in der praktischen Anwendung die Wafer der Inspektionseinrichtung bereits nach ihrem Drehwinkel ausgerichtet zugeführt.

In anderen Anwendungen ist aber eine derartige Vorausrichtung nicht möglich oder nicht wirtschaftlich. Für derartige Fälle ist bekannt, den Wafertisch drehbar auszuführen oder den Wafer aus dem Waferlager einer sogenannten Prealignment-Einrichtung zuzuführen, welche separat von der Inspektionseinrichtung angeordnet ist.

Die deutsche Patentanmeldung DE 199 25 653 A1 zeigt ein System zum Steuern der Ausrichtung eines Halbleiterwafers, wobei der Wafer mittels eines Wafertransportarms aus einem Träger entnommen und zu einer Ausrichtungswandlereinheit transportiert werden kann. Ein aus der deutschen Patentanmeldung DE 10 2009 026 187 A1 bekannter drehbarer Waferträger ist komplex im Aufbau und in seiner Bewegung in der Inspektionseinrichtung. Eine aus der US-Patentanmeldung US2002/0039436 A1 bekannte Prealignment-Einrichtung weist unter anderem den Nachteil auf, dass der Wafer mittels einer separaten Handhabungseinrichtung einen zusätzlichen Weg aus dem Lager in die Prealignment-Einrichtung und aus der Prealignment-Einrichtung zu dem Wafertisch zurücklegen muss, was sich insbesondere negativ auf die erreichbare minimale Inspektionsdauer auswirkt. Ein Wafertransportsystem mit einer Waferausrichtvorrichtung gemäß dem Stand der Technik ist in der Patentanmeldung WO 01/40086 A1 gezeigt.

Der Erfindung liegt die Aufgabe zugrunde, Vorrichtungen und Verfahren zur Verfügung zu stellen, welche einen hohen Durchsatz an Wafern mit einem vereinfachten Handling und/oder kleineren Verfahrwegen kombinieren.

Diese Aufgabe wird gelöst durch eine Waferausrichtvorrichtung zur Ablage eines Wafers in einer vorbestimmten Drehwinkellage mit den Merkmalen des unabhängigen Anspruchs 1 und ein Verfahren zum Ausrichten eines Wafers auf eine vorbestimmte Drehwinkellage mit den Merkmalen des unabhängigen Anspruchs 8. Ein Wafertransportsystem, eine Waferinspektionsanlage und ein Verfahren zum Transport eines Wafers sowie bevorzugte Weiterbildungen der Erfindung sind Gegenstand der abhängigen Ansprüche.

Gemäß einem Aspekt der Erfindung weist eine Waferausrichtvorrichtung zur Ablage eines Wafers in einer vorbestimmten Drehwinkellage einen Wafertisch mit einer Tischaufnahme zur Aufnahme des Wafers in einer Tischaufnahmeebene und ein Ausrichtmittel mit einer zur Ausrichtung des Wafers auf eine vorbestimmte Drehwinkellage eingerichteten Ausrichtaufnahme auf. Dabei ist die Ausrichtaufnahme bei der Aufnahme des Wafers in einer' Ausrichtposition oberhalb der Tischaufnahmeebene des Wafertisches angeordnet. Wenigstens eines von der Ausrichtaufnahme und der Tischaufnahme ist eingerichtet, durch eine vertikale Relativbewegung gegenüber dem anderen von der Ausrichtaufnahme und der Tischaufnahme einen in der Ausrichtaufnahme aufgenommen Wafer bei einem Queren der Ausrichtaufnahme und der Tischaufnahmeebene auf der Tischaufnahme abzulegen.

Dadurch kann in vorteilhafter Weise der Verfahrweg des Wafers zwischen dem Ausrichtmittel und dem Wafertisch reduziert werden. Ebenso kann dadurch eine vorteilhafte kinematische Trennung der Ausrichtmechanik und des Wafertisches erreichbar sein.

In einer bevorzugten Ausführung kann der Wafer nach dem Ausrichten durch ein Absenken der Ausrichtaufnahme auf der Tischaufnahme ablegbar sein.

Eine Tischaufnahme zur Aufnahme des Wafers kann vorliegend mit wenigstens ein, insbesondere zwei oder drei Tischaufnahmeelementen ausgebildet sein, wobei die Tischaufnahmeelemente vorzugsweise wenigstens eine ebene Auflageoberfläche zur Aufnahme einer der beiden flächigen Oberflächen des Wafers aufweisen.

Eine Tischaufnahmeebene kann im Sinne der Erfindung insbesondere eine horizontale Ebene sein, in welcher die Ablagefläche wenigstens einer, insbesondere aller, Tischaufnahmeelemente angeordnet ist. Vorzugsweise ist die Tischaufnahmeebene innerhalb der vertikalen Erstreckung (in z-Richtung) des Wafertisches angeordnet. Die Tischaufnahmeebene kann jedoch auch oberhalb oder unterhalb davon oder beweglich angeordnet sein.

In verschiedenen Ausführungen im Sinne der Erfindung weist der Wafertisch wenigstens ein metallisches Material, insbesondere ein Stahl- und/oder ein Aluminium-Material, ein Keramikmaterial und/oder ein Kunststoffmaterial auf oder besteht aus einem solchen Material oder einer Kombination, Verbindung oder Legierung aus wenigstens zwei solcher Materialien.

Unter einer Drehwinkellage eines Wafers kann vorliegend die Ausrichtung vorbestimmter, insbesondere gehäuft auftretender, Kanten- und/oder Oberflächenfeatures des Wafers, relativ zum Wafertisch, verstanden werden. Unter einer vorbestimmten Drehwinkellage ist vorzugsweise diejenige Drehwinkellage des Wafers zu verstehen, welche im Sinne eines nachgelagerten Inspektionsprozesses des Wafers, insbesondere einer Oberflächeninspektion des Wafers, als wünschenswert und/oder notwendig festgelegt ist.

Die Ausrichtposition der Ausrichtaufnahme definiert sich vorzugsweise auch durch die z-Position, an welcher der Wafer bei seiner Drehwinkelausrichtung in der Ausrichtaufnahme aufgenommen ist.

Im Sinne einer vertikalen Relativbewegung der Ausrichtaufnahme und der Tischaufnahme zueinander kann vorgesehen sein, dass sich ausschließlich die Ausrichtaufnahme vertikal nach unten bewegt, dass sich ausschließlich die Tischaufnahme vertikal nach oben bewegt, oder, dass sich sowohl die Ausrichtaufnahme nach unten als auch die Tischaufnahme nach oben bewegt. Unter einem Queren der Ausrichtaufnahme und der Tischaufnahmeebene ist insbesondere zu verstehen, dass sich ändert, welches der beiden Bauteile in Bezug auf die z-Richtung eine höhere Position einnimmt.

Erfindungsgemäß weist der Wafertisch der Waferausrichtvorrichtung eine Ausnehmung auf, durch welche hindurch die Ausrichtaufnahme vertikal verfahrbar ist, und deren Begrenzung wenigstens teilweise als wenigstens ein Tischaufnahmeelement ausgebildet ist.

Dadurch kann in vorteilhafter Weise ein kleiner Bauraum der Waferausrichtvorrichtung erreicht werden. Ebenso kann vorteilhafterweise die Schwerkraft bei der Ablage des Wafers auf einem Tischaufnahmeelement genutzt werden.

Unter einer Ausnehmung des Wafertisches kann im Sinne der Erfindung ein teilweise oder rundherum begrenzter, durchgehender Ausbruch aus dem Material des Wafertisches zu verstehen sein. Vorzugsweise ist die Ausnehmung in Form und Größe derart ausgebildet, dass die Ausrichtaufnahme ohne Anpassungsbewegungen (wie kippen und/oder verschwenken) durch sie hindurch vertikal verfahren werden kann und/oder dass der Wafer bei seiner Ablage auf der Tischaufnahme bezogen auf die z-Richtung bis zu einem als Tischaufnahmeelement ausgebildeten Teil der Begrenzung in die Ausnehmung aufgenommen werden kann.

Gemäß einer bevorzugten Weiterbildung greift bei der Ablage des Wafers auf der Tischaufnahme wenigstens ein Tischaufnahmeelement in eine senkrechte Projektion der Waferoberfläche radial ein.

Dadurch kann der Aufbau der Waferausrichtvorrichtung und insbesondere des Wafertisches vereinfacht werden, insbesondere indem eine separate Montage von Tischaufnahmeelementen vermieden wird.

Unter einer senkrechten Projektion der Waferoberfläche ist vorliegend insbesondere eine Projektion des Querschnitts des Wafers an einer seiner flächigen Oberflächen in einer dazu orthogonalen Richtung (hier z-Richtung) zu verstehen, welche einen zu einer z-Richtung parallelen, unendlichen Zylinder darstellt. Wenn nun der Wafer in z-Richtung entlang dieser Projektion bewegt wird, wird er vorzugsweise an der z-Position, an welcher ein Tischaufnahmeelement radial eingreift, auf diesem Tischaufnahmeelement abgelegt.

Gemäß einer bevorzugten Weiterbildung weist die Waferausrichtvorrichtung zusätzlich eine Ausrichtsensoreinrichtung zur Detektion einer Drehwinkellage des Wafers bei Ablage in der Ausrichtaufnahme auf. Dabei weist die Ausrichtsensoreinrichtung wenigstens eine Kamera und/oder einen Lichtvorhang zur optischen Detektion von Oberflächen- und/oder Kantenfeatures des Wafers auf.

Die Ausrichtaufnahme ist eingerichtet, den Wafer in Abhängigkeit von einem mittels der Ausrichtsensoreinrichtung ermittelten Unterschied zwischen der detektierten Drehwinkellage und der vorbestimmten Drehwinkellage rotatorisch auszurichten.

Dass die Waferausrichtvorrichtung eine Steuereinrichtung zur Auswertung von Sensordaten und/oder zur Steuerung verschiedenster Vorgänge der Waferausrichtvorrichtung, insbesondere auf Basis der mittels der Ausrichtsensoreinrichtung gesammelten Sensordaten, aufweist, versteht sich von selbst.

Durch die Detektion von Oberflächen- und/oder Kantenfeatures des Wafers können in vorteilhafter Weise gleichartige Features auf der Oberfläche oder an einer Kante aller Wafer benutzt werden, um eine reale (Ist-)Drehwinkellage des Wafers und damit eine gezielte Ausrichtung auf eine vorbestimmte Drehwinkellage mittels der Ausrichtaufnahme zu erleichtern.

Gemäß der Erfindung weist ein Wafertransportsystem zum Transport eines Wafers, insbesondere hin zu einer Inspektionsposition einer Waferinspektionsanlage, eine Waferausrichtvorrichtung nach einer Ausführung der Erfindung sowie ein Auszugsmittel mit einer Auszugsaufnahme für den Transport des Wafers von einem Lagerort in einem Waferlager zu der Ausrichtaufnahme auf. Die Auszugsaufnahme ist dabei vor einer Übergabe des Wafers in einer Übergabeposition oberhalb der Ausrichtaufnahme angeordnet. Dabei ist wenigstens eine von der Ausrichtaufnahme und der Auszugsaufnahme eingerichtet, durch eine vertikale Relativbewegung gegenüber der anderen von der Ausrichtaufnahme und der Auszugsaufnahme einen in der Auszugsaufnahme aufgenommenen Wafer bei einer Umkehr der relativen vertikalen Positionen der Ausrichtaufnahme und der Auszugsaufnahme zueinander auf der Ausrichtaufnahme abzulegen. Zusätzlich ist wenigstens eine, insbesondere jede, von der Auszugsaufnahme und der Ausrichtaufnahme in ihrer Ruheposition unterhalb der Tischaufnahmeebene des Wafertisches angeordnet.

Dadurch kann in vorteilhafter Weise der Verfahrweg des Wafers zwischen einem Waferlager und dem Ausrichtmittel reduziert werden. Ebenso kann dadurch eine vorteilhafte kinematische Trennung der Auszugsmechanik, der Ausrichtmechanik und/oder des Wafertisches ermöglicht werden, wodurch insbesondere der Wafertisch separat verfahren werden kann.

Erfindungsgemäß ist der Wafertisch bei einem Transport des Wafers in Richtung einer Inspektionsposition relativ zu dem Auszugsmittel und zu dem Ausrichtmittel verfahrbar, insbesondere mittels einer Transporteinrichtung des Wafertisches. Dabei ist das Auszugsmittel und das Ausrichtmittel, insbesondere während des Transports, jeweils unterhalb der Tischaufnahmeebene angeordnet. Dadurch kann die Anzahl von zu der Inspektionsposition zu transportierenden Teile und/oder das zu transportierende Gewicht minimiert werden.

Erfindungsgemäß ist das Auszugsmittel des Wafertransportsystems wenigstens mit der Auszugsaufnahme durch die Ausnehmung des Wafertisches hindurch verfahrbar. Dies kann eine kompakte Bauweise des Wafertransportsystems ermöglichen.

Gemäß einer bevorzugten Weiterbildung ist mittels der Ausrichtsensoreinrichtung eine Relativposition des Wafers zu der Tischaufnahme des Wafertisches ermittelbar. Dabei ist das Auszugsmittel eingerichtet, durch eine translatorische Bewegung in eine erste Richtung nötigenfalls eine von einem vorbestimmten Wert, insbesondere Null, abweichende Relativposition des Wafers in dieser Richtung auszugleichen. Zusätzlich oder als Alternative abweichende Position des Wafers in dieser Richtung auszugleichen.

Dadurch können die Anforderungen an die Genauigkeit der Positionierung der Wafer bei deren Bereitstellung reduziert werden.

Gemäß einer bevorzugten Weiterbildung ist der Wafertisch in einer ersten Richtung translatorisch festgelegt, welche vorzugsweise der Verfahrrichtung des Auszugsmittels beim Passieren der Ausrichtsensoreinrichtung entspricht. Zudem ist das Auszugsmittel in einer zweiten, zur ersten Richtung orthogonalen, Richtung translatorisch festgelegt und/oder das Ausrichtmittel in der ersten und in der zweiten Richtung translatorisch festgelegt.

Aufgrund der separaten und/oder vorbestimmten Zuweisung der verschiedenen Freiheitsgrade im Transport des Wafers an die unterschiedlichen Bauteile können diese einfacher, günstiger, kleiner und/oder leichter gestaltet werden.

Gemäß einem weiteren Aspekt der Erfindung weist eine Waferinspektionsanlage ein, zwei oder mehrere Wafertransportsysteme nach einer Ausführung der Erfindung auf, insbesondere um einen erhöhten und/oder vervielfachten Waferdurchsatz zu erreichen.

Die vorstehend im Kontext von Weiterbildungen einer Waferausrichtvorrichtung im Sinne der Erfindung beschriebenen Merkmale und Vorteile sind entsprechend auch im Rahmen der nachstehend nachbeschriebenen Verfahren zur Anwendung vorgesehen, und umgekehrt.

Gemäß einem weiteren Aspekt der Erfindung wird bei einem Verfahren zum Ausrichten eines Wafers auf eine vorbestimmte Drehwinkellage eine Ausrichtaufnahme eines Ausrichtmittels oberhalb der Tischaufnahmeebene einer Tischaufnahme eines Wafertisches angeordnet. Ferner wird dabei der Wafer in die Ausrichtaufnahme aufgenommen und mittels des Ausrichtmittels in der Ausrichtaufnahme rotatorisch auf eine vorbestimmte Drehwinkellage ausgerichtet, wobei das Ausrichten in Abhängigkeit von Messwerten einer Ausrichtsensoreinrichtung erfolgen kann. Zusätzlich wird wenigstens eine von der Ausrichtaufnahme und der Tischaufnahme vertikal relativ gegenüber der anderen von der Ausrichtaufnahme und der Tischaufnahme bewegt, so, dass die Ausrichtaufnahme und die Tischaufnahmeebene einander queren, wobei der Wafer auf der Tischaufnahme abgelegt wird.

Dadurch kann in vorteilhafter Weise der Verfahrweg des Wafers zwischen dem Ausrichtmittel und dem Wafertisch reduziert werden. Ebenso kann dadurch eine vorteilhafte kinematische Trennung der Ausrichtmechanik und des Wafertisches erreichbar sein.

Gemäß einer bevorzugten Weiterbildung wird beim Verfahren zum Ausrichten eines Wafers die Ausrichtaufnahme so weit unter die Tischaufnahmeebene abgesenkt, dass der ausgerichtete Wafer aus der Ausrichtaufnahme an die in der Tischaufnahmeebene angeordnete Tischaufnahme übergeben wird. Dabei wird bei der Aufnahme des Wafers in die Tischaufnahme wenigstens ein Teil der Waferoberfläche auf wenigstens einem Tischaufnahmeelement, insbesondere einem Teil der Begrenzung einer Ausnehmung des Wafertisches, abgelegt.

Dadurch kann in vorteilhafter Weise ein kleiner Bauraum der Waferausrichtvorrichtung erreicht werden. Ebenso kann vorteilhafterweise eine die Schwerkraft bei der Ablage des Wafers auf einem Tischaufnahmeelement genutzt werden.

Gemäß einer bevorzugten Weiterbildung wird bei einem Verfahren zum Transport des Wafers, insbesondere zu einer Inspektionsposition einer Waferinspektionsanlage, der Wafer mittels einer Auszugsaufnahme eines Auszugsmittels aus einem Waferlager entnommen und zu einer Position, insbesondere in z-Richtung, oberhalb der Tischaufnahme und der Ausrichtaufnahme verfahren. Dabei wird eine vertikale Relativposition der Auszugsaufnahme und der Ausrichtaufnahme zueinander in der Art verändert, insbesondere umgekehrt, dass der Wafer oberhalb der Tischaufnahme aus der Auszugsaufnahme in die Ausrichtaufnahme aufgenommen wird. Dabei wird der Wafer gemäß einer Ausführung der Erfindung ausgerichtet, in der Tischaufnahme aufgenommen und zu wenigstens einer Inspektionsposition der Waferinspektionsanlage verfahren.

Dadurch kann in vorteilhafter Weise der Verfahrweg des Wafers zwischen einem Waferlager und dem Ausrichtmittel reduziert werden. Ebenso kann dadurch eine vorteilhafte kinematische Trennung der Auszugsmechanik, der Ausrichtmechanik und/oder des Wafertisches erreichbar sein, wodurch insbesondere ein separates Verfahren des Wafertisches erreichbar sein kann.

Gemäß einer bevorzugten Weiterbildung wird mittels einer Ausrichtsensoreinrichtung eine Position des aus dem Waferlager entnommenen Wafers auf dem Auszugsmittel bezüglich einer ersten horizontalen Richtung ermittelt. In Abhängigkeit von der ermittelten Position des Wafers in dieser Richtung wird das Auszugsmittel derart translatorisch bewegt, dass der Wafer an der durch eine Führung des Wafertisches bezüglich einer zweiten, zur ersten orthogonalen, Richtung vorgegebenen Position in der ersten Richtung, insbesondere über das Ausrichtmittel, an die Tischaufnahme übergeben wird.

Dadurch können die Anforderungen an die Genauigkeit der Positionierung der Wafer bei deren Bereitstellung reduziert werden.

Gemäß einer bevorzugten Weiterbildung wird mittels einer Ausrichtsensoreinrichtung eine Position des aus dem Waferlager entnommenen Wafers in der zweiten Richtung auf dem Auszugsmittel ermittelt und in Abhängigkeit von der ermittelten Position des Wafers in dieser Richtung der Wafertisch derart translatorisch bewegt, dass der Wafer an der, bezüglich der zweiten Richtung ermittelten, Position, insbesondere über das Ausrichtmittel, an die Tischaufnahme übergeben wird.

Dadurch können die Anforderungen an die Genauigkeit der Positionierung der Wafer bei deren Bereitstellung reduziert werden.

Gemäß einer bevorzugten Weiterbildung wird/werden das Auszugsmittel und/oder das Ausrichtmittel nach der Übergabe des Wafers an den Wafertisch in dessen/deren jeweilige Ruheposition unterhalb der Tischaufnahmeebene verfahren.

Weitere bevorzugte Weiterbildungen und beispielhafte Ausführungen der Erfindung werden nachfolgend insbesondere in Verbindung mit den Figuren näher erläutert. Wenigstens teilweise schematisiert dargestellt zeigt dabei:
- Fig. 1: in einer Perspektivansicht eine beispielhafte Ausführung einer erfindungsgemäßen Waferausrichtvorrichtung mit einem mittels des Auszugsmittels aus einem Waferlager entnommenen Wafer;
- Fig. 2: die Vorrichtung aus Fig. 1 in der dort gezeigten Stellung in einer anderen Perspektivansicht;
- Fig. 3: in einer Perspektivansicht die Vorrichtung aus Fig. 1, wobei der Wafer durch den Lichtvorhang verfahren wird;
- Fig. 4: in einer Seitenansicht die Vorrichtung aus Fig. 1 in der in Fig. 3 gezeigten Stellung;
- Fig. 5: in einer Perspektivansicht die Vorrichtung aus Fig. 1, wobei der Wafer mittels des Auszugsmittels in einer Übergabeposition oberhalb der Ausrichtaufnahme angeordnet ist;
- Fig. 6: in einer Perspektivansicht die Vorrichtung aus Fig. 1, bei welcher der Wafer auf der Ausrichtaufnahme abgelegt ist;
- Fig. 7: in einer Seitenansicht die Vorrichtung aus Fig. 1 in der in Fig. 6 gezeigten Position;
- Fig. 8: in einer Perspektivansicht die Vorrichtung aus Fig. 1 nach dem Ausrichten des Wafers;
- Fig. 9: in einer Perspektivansicht die Vorrichtung aus Fig. 1 nach der Ablage des Wafers auf der Tischaufnahme;
- Fig. 10: in einer Seitenansicht die Vorrichtung aus Fig. 1 in der in Fig. 9 gezeigten Position; und
- Fig. 11: in einer Perspektivansicht ein Wafertransportsystem mit einer Waferausrichtvorrichtung gemäß Fig. 1 mit einem in y-Richtung verfahrenen Wafertisch.

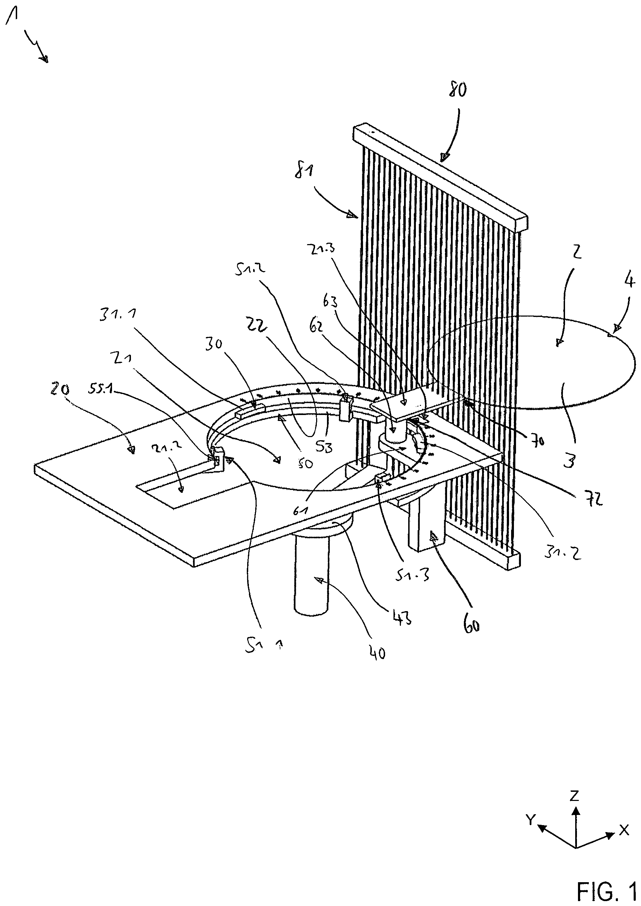

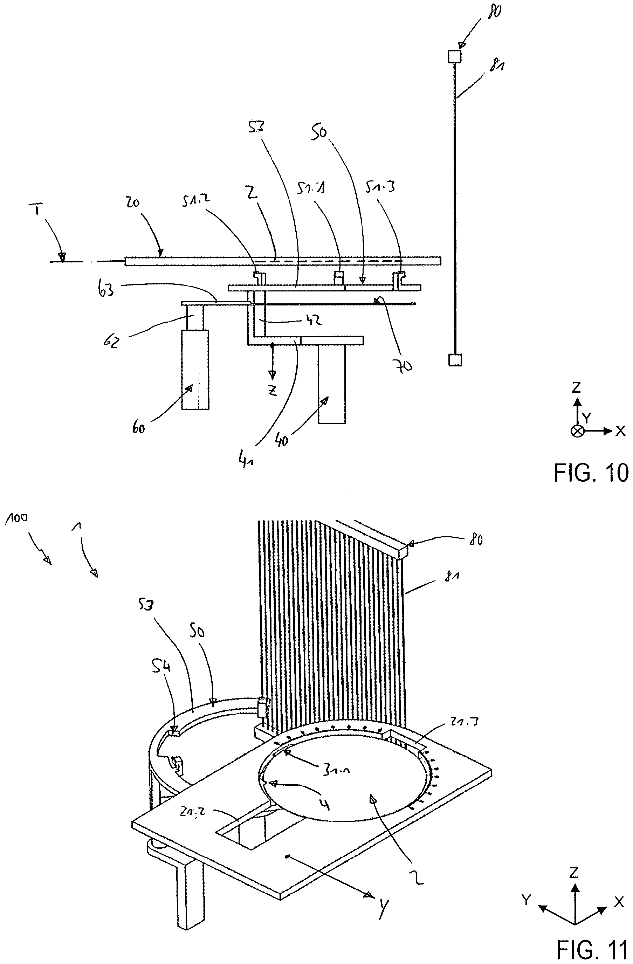

Die Figuren zeigen ein Ausführungsbeispiel eines Wafertransportsystems 100, wobei letzteres nur in Fig. 11 gezeigt ist, während die Darstellungen in den Fig. 1 bis 10 ausschließlich Komponenten (bzw. deren Positionen) zeigen, welche der Waferausrichtvorrichtung 1 des Wafertransportsystems 100 zugeordnet werden können. Die Waferausrichtvorrichtung 1 des Ausführungsbeispiels weist einen Wafertisch 20, ein Ausrichtmittel 40, ein Auszugsmittel 60 sowie eine Ausrichtsensoreinrichtung 80 auf.

Der Wafertisch 20 ist im vorliegenden Ausführungsbeispiel im Wesentlichen aus einem Aluminium-Material ausgebildet. In ebenfalls vorgesehenen, nicht dargestellten Ausführungsbeispielen kann der Wafertisch 20 mit oder aus einem Stahl-, einem Keramik- und/oder mit einem Kunststoffmaterial ausgebildet sein.

Der Tisch 20 ist im Ausführungsbeispiel aus einem Blech gefräst, wobei das Blech eine konstante Wandstärke von wenigstens zwei, insbesondere vier Millimetern aufweist. Vorzugsweise ist eine maximale Wandstärke von wenigen, insbesondere zwei oder drei Zentimetern vorgesehen. In einem nicht dargestellten Ausführungsbeispiel weist das Blech innerhalb der genannten Grenzen eine variable - an Belastungsverhältnisse angepasste - Wandstärke auf.

In einem weiteren, nicht dargestellten Ausführungsbeispiel wird der Wafertisch nicht aus einem Vollmaterial gefräst, sondern in Sandwichblechtechnik aufgebaut.

Der Tisch 20 weist eine rechteckige Grundform auf, wobei zur Materialersparnis eine oder mehrere Ecken abgerundet sein können. Ausgehend von der oberen Oberfläche des Tisches 20 ist eine durchgehende Ausnehmung 21 eingebracht, welche im Ausführungsbeispiel eine umlaufende Begrenzung 22 aufweist und insbesondere der Aufnahme des Wafers 2 an den Tischaufnahmeelementen 31 der Tischaufnahme 30 dient. Die Ausnehmung 21 kann aber, insbesondere zur Materialersparnis, auch seitlich teilweise offen ausgestaltet sein.

Die Begrenzung 22 der Ausnehmung 21 ist insbesondere so ausgebildet, dass die Tischaufnahmeelemente 31.1, 31.2 und 31.3 als Teil dieser Begrenzung 22 ausgebildet sind.

Dies ermöglicht insbesondere einen einfachen Aufbau des Wafertisches 20, dessen Ausnehmung 21 aus dem Blech vorzugsweise gefräst ist, wobei in diesem Fräsvorgang auch die Tischaufnahmeelemente 31 geformt werden können.

Die Ausnehmung 21 ist zusätzlich so geformt, dass das Auszugsmittel 60 mit seiner Auszugsaufnahme 70 in z-Richtung durch die Ausnehmung 21 verfahren werden kann. Dazu sind Bereiche 21.2 und 21.3 der Ausnehmung 21 vorgesehen, wohingegen der Bereich 21.1 der Ausnehmung 21 zur Aufnahme des Wafers 2 und zum Queren durch die Aufnahmen 40 und/oder 60 vorgesehen ist.

Der Wafertisch 20 kann in y-Richtung wenigstens zwischen der Position, an welcher er den Wafer aufnimmt, und einer Inspektionsposition (in den Figuren nicht dargestellt) verfahren werden. Zum Ausgleich von Fehllagen des Wafers in y-Richtung kann der Wafertisch auch über die Waferaufnahmeposition hinaus in y-Richtung verfahrbar sein. Wenn der Wafertisch in y-Richtung verfahren wird, verbleiben das Auszugsmittel 60 und das Ausrichtmittel 40 an der in den Figuren dargestellten y-Position.

Das Auszugsmittel 60 ist translatorisch in z-Richtung und in x-Richtung verfahrbar. Durch die Verfahrbarkeit in x-Richtung kann mittels der Auszugsaufnahme 70 ein Wafer 2 aus einem Waferlager (nicht dargestellt) entnommen und zu einer Übergabeposition P_{U} verfahren werden. Im Ausführungsbeispiel ist auf diesem Verfahrweg eine Ausrichtsensoreinrichtung 80 mit einem Lichtvorhang 81 angeordnet. Mittels dieses Lichtvorhangs kann die Oberfläche 3 des Wafers 2 auf das Vorhandensein und/oder die Ausrichtung bestimmter Oberflächenfeatures, wie beispielsweise Leiterbahnen, Seriennummern, Teststrukturen oder Ähnliches überprüft werden. Ebenso kann mittels des Lichtvorhangs 81 eine Detektion von Kantenfeatures 4, wie beispielsweise der Notch 4 erfolgen, die in die Kante des Wafers 2 des Ausführungsbeispiels eingebracht ist.

Anhand des Vorhandenseins und/oder der Ausrichtung solcher Oberflächen und/oder Kantenfeatures 4 kann eine Drehwinkellage α des aus dem Waferlager entnommenen Wafers 2 ermittelt werden, indem die entsprechenden Messwerte der Ausrichtsensoreinrichtung in einer dafür eingerichteten Steuereinrichtung analysiert und ausgewertet werden.

Die dazu notwendigen Daten werden aufgenommen, wenn die Waferoberfläche 3 mittels des Auszugsmittels 60 in x-Richtung durch den Lichtvorhang 81 verfahren wird.

Anstatt eines Lichtvorhangs 81 oder zusätzlich hierzu ist in einem nicht dargestellten Ausführungsbeispiel eine Kamera, insbesondere mit Bilderkennung, vorgesehen, deren Daten in analoger Weise mittels einer Steuereinrichtung analysiert und ausgewertet werden können, um Features wie die Notch 4 oder andere zu erkennen und daraus eine aktuelle Drehwinkellage α des Wafers 2 auf der Aufnahme 70 abzuleiten.

Wenn das Auszugsmittel 60 derart in der Übergabeposition P_{U} angeordnet ist, dass der Wafer 2 genau über der Ausnehmung 21.1 und über den sich durch die Ausnehmung 21.1 oberhalb der Tischaufnahmeebene T erstreckenden Ausrichtaufnahmeelementen 51 des Ausrichtmittels 40 angeordnet ist, wird das Auszugsmittel 60 nach unten in z-Richtung verfahren. Dabei wird der Wafer 2 mit der der Oberfläche 3 gegenüberliegenden Oberfläche auf den Ausrichtaufnahmeelementen 51.1, 51.2 und 51.3 abgelegt.

Die x-Führung des Auszugsmittels 60 ist in y-Richtung versetzt zu der Drehachse der Drehbasis 43 des Ausrichtmittels 40 angeordnet, um mit diesem bei einem Verfahren nicht zu kollidieren. Um trotzdem eine, bezogen auf die Tischaufnahme 30 mittige Führung in x-Richtung des Wafers 2 zu ermöglichen, weist das Auszugsmittel 60 ein Auszugsversatzelement 61 auf, das den beschriebenen Abstand in y-Richtung überwindet. Das Auszugsversatzelement kann in einer z-Position, welche höher ist als die höchste z-Position einer Drehbasis 43 des Ausrichtmittels 40, in x-Richtung verfahren werden.

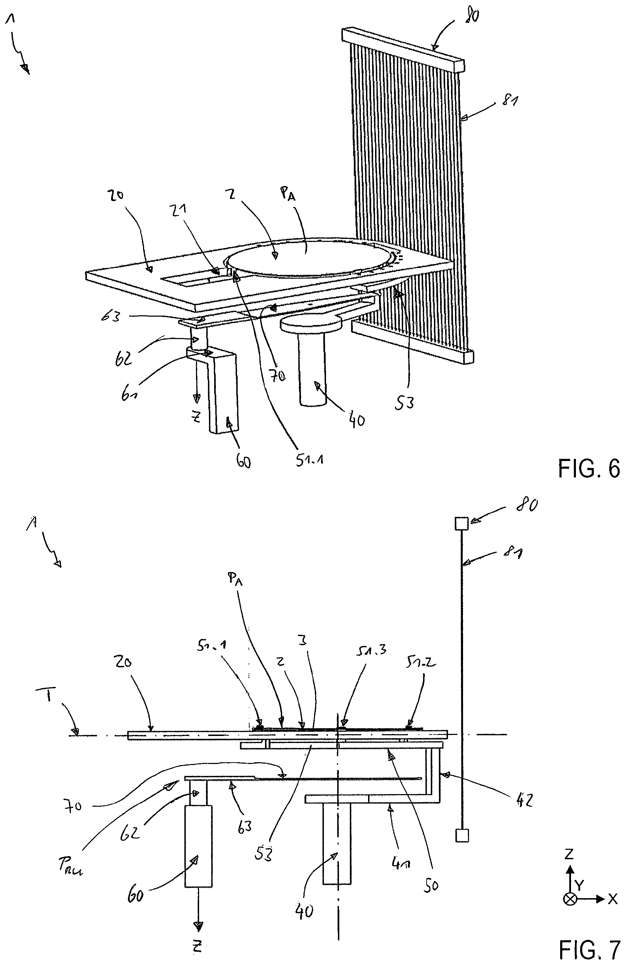

Die Ruheposition P_{RU} des Auszugsmittels 60, in welche das Auszugsmittel 60 verfährt, wenn es nicht gebraucht wird, ist beispielsweise in Fig. 7 dargestellt. Die Ruheposition P_{RA}, in welche das Ausrichtmittel 40 verfährt, wenn es nicht gebraucht wird, ist in den Figuren nicht dargestellt, entspricht jedoch der translatorischen z-Stellung in Fig. 10 und der rotatorischen z-Stellung in Fig. 1.

Das Ausrichtmittel 40 ist bei der Übernahme des Wafers von der Auszugsaufnahme 70 durch die Ausnehmung 21 des Wafertisches hindurch angeordnet, sodass sich wenigstens die Ausrichtaufnahmeelemente 51 oberhalb der Tischaufnahmeebene T, welche durch Auflageflächen der Tischaufnahmeelemente 31 definiert ist, befinden. Wenn ein Wafer 2 auf diesen Ausrichtaufnahmeelementen 51 abgelegt ist, kann der Wafer 2 durch Drehung des Ausrichtmittels 40 und damit auch der Ausrichtaufnahme 50 mit dem Ausrichtring 53, welcher die Ausrichtaufnahmeelemente 51 aufweist, ausgerichtet werden. Dazu wird mittels der nicht dargestellten Steuereinrichtung die aus Sensordaten der Ausrichtsensoreinrichtung 80 ermittelte reale Drehwinkellage α des Wafers 2 mit einer vorbestimmten Drehwinkellage α_{S} verglichen, und die Ausrichtung durchgeführt (d.h. insbesondere durch die Steuereinrichtung aktuiert), falls eine Winkeldifferenz zwischen der Drehwinkellage α und der vorbestimmten Drehwinkellage α_{S} besteht.

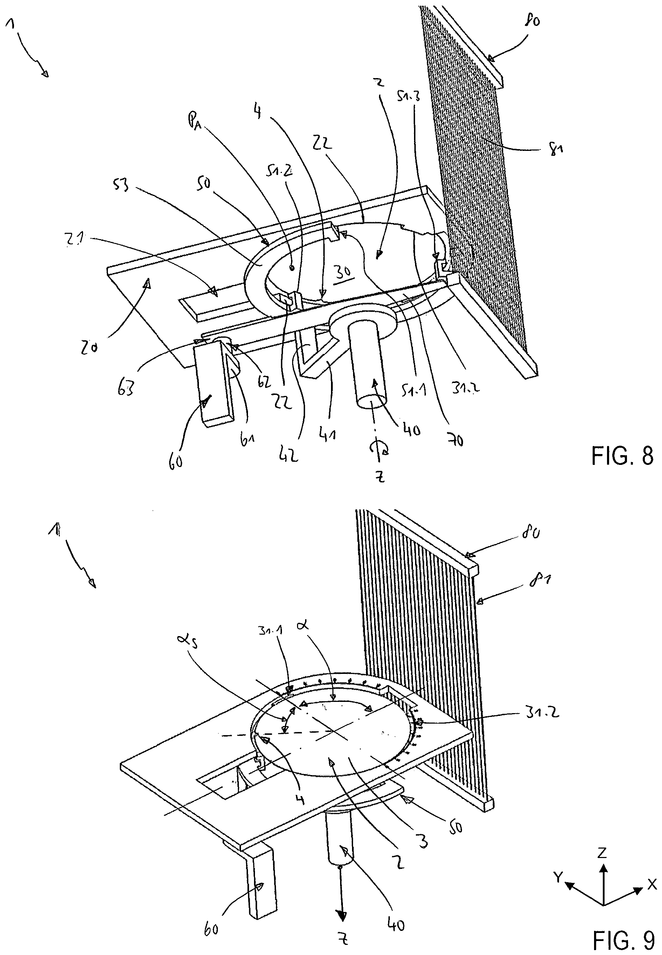

Während einer Ausrichtung mittels des Ausrichtmittels 40 ist im vorliegenden Ausführungsbeispiel das Auszugsmittel 60 in seiner Ruheposition angeordnet, sodass eine Drehung des Ausrichtmittels 40 um die z-Achse in einem sehr großen Winkelbereich von ca. 330 Grad möglich ist. Beispielsweise aus Fig. 7 oder Fig. 8 ist ersichtlich, dass die Beschränkung des Drehwinkelbereichs des Ausrichtmittels 40 aus einer ansonsten erfolgenden Kollision zwischen der Auszugsaufnahme 70 und der Ausrichtstütze 42 resultiert. Vorzugsweise werden mögliche Kollisionen durch eine entsprechende Programmierung der Steuerungseinrichtung abgefangen.

Der Fall einer nicht mittels eines ununterbrochenen Ausrichtungsvorgangs auszugleichenden Differenz zwischen realer Drehwinkellage α und vorbestimmter Drehwinkellage α_{S}, die aufgrund der Anordnung des Auszugsmittels 60 und des Ausrichtmittels 40 in diesem Ausführungsbeispiel bei einer Ausrichtung eine Kollision verursachen würden, kann beispielsweise dadurch gelöst werden, dass das Ausrichten in zwei Schritten, mit einer zwischenzeitlichen Ablage des Wafers auf der Tischaufnahme, einem rotatorischen Verfahren des Ausrichtmittels ohne Wafer und einem abschließenden erneuten Aufnehmen des Wafers mit Ausrichtung erfolgt.

Das Ausrichtmittel 40 weist eine Drehbasis 43 auf, an welcher ein horizontales Ausrichtversatzelement 41 befestigt ist, an welchem wiederum die vertikale Ausrichtstütze 42 angeordnet ist, die die Ausrichtaufnahme 50 mit ihrem Ausrichtring 53 und den daran angeordneten Ausrichtaufnahmeelementen 51 trägt.

Die Ausrichtaufnahmeelemente 51 sind in dem Ausführungsbeispiel so geformt, dass sie in der Ausrichtposition (bzgl. z-Richtung) jeweils eine Ausnehmung 55 aufweisen, die so ausgebildet ist, dass bei der Ausrichtung des Wafers und der damit verbundenen Drehbewegung eine Kollision mit den Tischaufnahmeelementen 31 vermieden wird.

Nach dem Abschluss des Ausrichtvorgangs wird das Ausrichtmittel 40 vertikal nach unten in z-Richtung verfahren, wobei die Tischaufnahmeelemente 31 auf ihren Ablageflächen den Wafer 2 übernehmen, sobald die Ausrichtaufnahmeelemente 51 in der Ebene, in der sie den Wafer tragen, die Tischaufnahmeebene T queren. Anschließend wird die Ausrichtaufnahme 50 und damit das Ausrichtmittel 50 weiter in die Ruheposition P_{RA} verfahren.

Der Wafer 2 ist damit in der gewünschten Drehwinkellage α_{S} in der Tischaufnahme 30 des Wafertisches 20 abgelegt. Der Wafertisch 20 kann dann, insbesondere mittels einer Führung in y-Richtung, zu einer Inspektionsposition der Waferinspektionsanlage verfahren werden, wo der Wafer 2 in der vorbestimmten Drehwinkellage α_{S} inspiziert werden kann.

Die Figuren 1 bis 11 zeigen in verschiedenen Ansichten in einer einem beispielhaften Verfahren entsprechenden Reihenfolge unterschiedliche Verfahrensschritte im Sinne der Erfindung. Dies ist nachfolgend exemplarisch beschrieben.

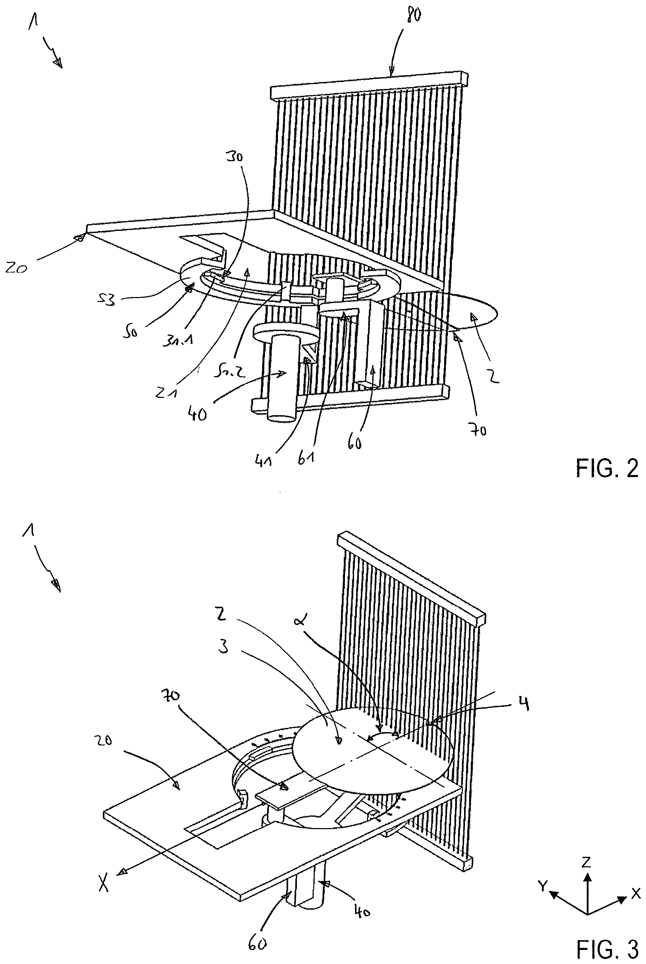

In den Figuren 1 und 2 ist ein Wafer 2 gezeigt, welcher aus einem nicht dargestellten Waferlager auf die Auszugsaufnahme 70 des Auszugsmittels 60 aufgelegt wurde.

In Fig. 3 ist dargestellt, wie der Wafer 2 aus der Auszugsaufnahme 70 mit dem Auszugsmittel 60 in x-Richtung durch den Lichtvorhang 81 verfahren wird. Dabei wird im Ausführungsbeispiel die Position der Notch 4 erfasst und aus dieser Position mittels einer Steuereinrichtung die Drehwinkellage α des Wafers ermittelt. Zusätzlich kann mittels der Ausrichtsensoreinrichtung eine x-Position und/oder y-Position des Wafers auf der Auszugsaufnahme ermittelt werden. Dadurch ist es möglich, eventuelle Abweichungen von einer vorgesehenen Position des Wafers auf der Auszugsaufnahme 70 auszugleichen. Ein solcher Ausgleich kann in x-Richtung mittels des Auszugsmittels 60 erfolgen, welches bei einer detektierten Abweichung in x-Richtung selbst den Abweichungsbetrag zusätzlich oder abgezogen in x-Richtung verfährt, bis der Wafer 2 entsprechend der Abweichung die vorgesehene Übergabeposition P_{U} erreicht hat (bzgl. x-Richtung). In y-Richtung kann eine solche Korrektur mittels einem Verfahren des Wafertisches 20 in y-Richtung um die detektierte Abweichung in positive oder negative y-Richtung erfolgen.

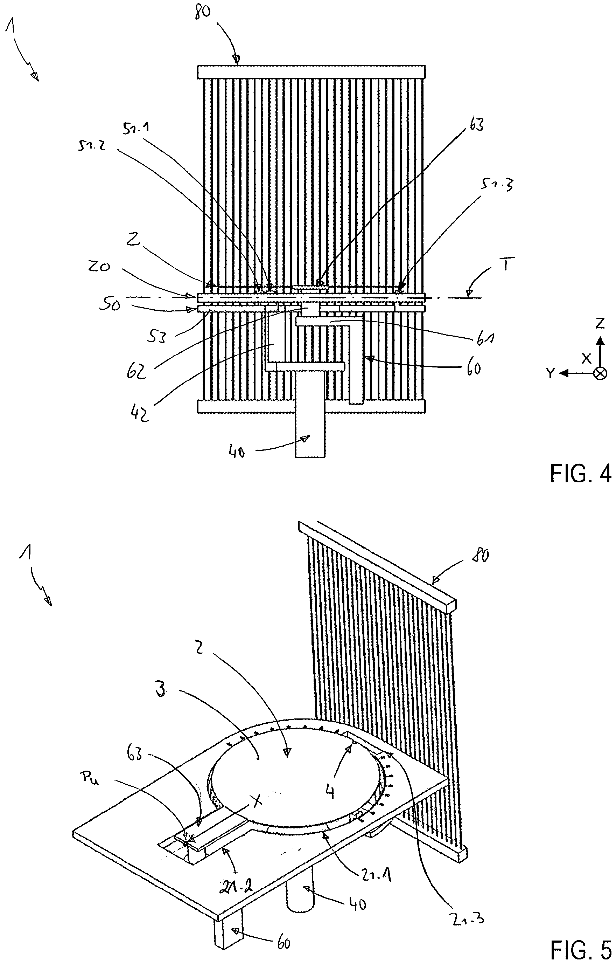

Fig. 4 zeigt eine Seitenansicht der Konfiguration der Waferausrichtvorrichtung 1 beim oder kurz nach dem Verfahren durch den Lichtvorhang 81. Hier wird ersichtlich, dass sich sowohl das Auszugsmittel 60 mit den Auszugsstützen 62 und 63, als auch das Ausrichtmittel 40 mit den Ausrichtaufnahmeelementen 51 durch die Ausnehmung 21 (in dieser Figur nicht erkennbar) hindurch erstrecken, und dabei die Tischaufnahmeebene T schneiden bzw. queren.

Ebenso ist aus Fig. 4 erkennbar, wie das Auszugsmittel 60 und das Ausrichtmittel 40 in y-Richtung versetzt zueinander angeordnet sind, insbesondere um eine Kollision beim Verfahren des einen und/oder des anderen zu umgehen.

In der Darstellung der Fig. 5 wurde das Auszugsmittel 60 bereits in x-Richtung so weit verfahren, dass der Wafer 2 an seiner Übergabeposition P_{U} angekommen ist, an welcher er in z-Richtung an die Ausrichtaufnahme übergeben werden kann. Die Übergabeposition P_{U} ist in Fig. 5 an der horizontalen Auszugsstütze 63 eingezeichnet und kann somit ggf. eventuelle Abweichungen der gewünschten Waferposition auf der Auszugsaufnahme 70 in x-Richtung enthalten. Obwohl die Übergabepositon P_{U} in dieser Figur an dem Auszugsmittel 60 eingetragen ist, bezieht sich die Übergabeposition P_{U}, wie im vorherigen Satz dargestellt auf die Position des Wafers 2, hier insbesondere in x-Richtung.

In Fig. 6 ist die Waferausrichtvorrichtung 1 dargestellt, nachdem der Wafer 2 von der Auszugsaufnahme 70 auf die Ausrichtaufnahmeelemente 51 der Ausrichtaufnahme 50 übergeben wurde, indem das Auszugsmittel 60 in z-Richtung nach unten, vorzugsweise in seine Ruheposition P_{RU}, verfahren wird. Der Wafer 2 ist also nunmehr in der Ausrichtposition P_{A} in der Ausrichtaufnahme 50 in seiner Drehwinkellage α aufgenommen.

Aus Fig. 7 ist erkennbar, dass der Wafer 2 dabei immer noch oberhalb der Tischaufnahmeebene T angeordnet ist, weil die Ablageflächen der Ausrichtaufnahmeelemente 51 ebenfalls oberhalb dieser Tischaufnahmeebene T angeordnet sind. Das Auszugsmittel 60 mit der Auszugsaufnahme 70 ist in seiner Ruheposition P_{RU} so angeordnet, dass nun eine Ausrichtung des Wafers 2 mittels des Ausrichtmittels 40 durch Rotation um die z-Achse weitgehend kollisionsfrei (rotatorischer Freiheitsgrad ca. 330 Grad) erfolgen kann. In der Darstellung der Fig. 7 ist die Ausrichtstütze 42 erkennbar noch in ihrer rotatorischen Ausgangs- bzw. Ruheposition angeordnet.

Dahingegen ist in der Darstellung der Fig. 8 die Ausrichtung des Wafers 2 auf die vorbestimmte Drehwinkellage α_{S} bereits erfolgt, wie insbesondere durch die rotatorische Position der Ausrichtstütze 42 und durch die rotatorische Position der Notch 4 ersichtlich ist. Dabei liegt der Wafer nach wie vor in seiner Ausrichtposition P_{A} (bzgl. translatorischer z-Position), welche oberhalb der Tischaufnahmeebene T liegt.

In Fig. 9 ist der Wafer 2, ausgerichtet auf die vorbestimmte Drehwinkellage α_{S}, auf den Tischaufnahmeelementen 31.1, 31.2 und 31.3 abgelegt. Das Ablegen des Wafers 2 erfolgt dabei durch eine Absenkung des Ausrichtmittels 40 in z-Richtung, im Laufe derer die Ausrichtaufnahmeelemente 51 auf eine z-Position unterhalb der Tischaufnahmeebene T verfahren werden, wobei beim Queren der Tischaufnahmeebene T die Tischaufnahmeelemente 31 die oberhalb von den Aufnahmeflächen der Tischaufnahmeelemente angeordneten Oberflächenteile des Wafers 2 aufnehmen.

Das Ausrichtmittel 40 wird dann weiter in seine vertikale Ruheposition P_{RA} verfahren (und ohne Darstellung in den Figuren auch in seine rotatorische Ruheposition).

Diese Situation ist auch in Fig. 10 dargestellt, wobei aus der dort gezeigten Seitenansicht erkennbar ist, dass nunmehr das Ausrichtmittel 40 ebenso wie das Auszugsmittel 60 jeweils in ihrer gesamten Erstreckung in z-Richtung unterhalb der z-Erstreckung des Wafertisches und der Tischaufnahmeebene T angeordnet sind.

Damit kann der Wafertisch - wie in Fig. 11 dargestellt - ohne Kollision mit dem Ausrichtmittel 40 oder dem Auszugsmittel 60 in y-Richtung in Richtung einer Inspektionsposition der nicht dargestellten Waferinspektionsanlage verfahren werden. Dies geschieht mittels einer in Fig. 11 nicht dargestellten y-Transporteinrichtung des Wafertransportsystems 100.

Ebenso wie die y-Transporteinrichtung für den Wafertisch ist auch die x-Transporteinrichtung und die z-Transporteinrichtung des Auszugsmittels wie die z-Transporteinrichtung und die z-Rotationseinrichtung des Ausrichtmittels 40 in den Figuren 1 bis 11 nicht dargestellt. Vorzugsweise sind diese Transporteinrichtungen als Elektromotoren, insbesondere als Linearmotoren oder Rotationsmaschinen ausgebildet oder weisen jeweils zumindest einen solchen auf.

Die nicht dargestellte Steuerungseinrichtung ist sowohl eingerichtet, Messdaten aus der Ausrichtsensoreinrichtung 80 zu analysieren und auszuwerten, als auch eingerichtet, um die in den letzten Absätzen beschriebenen Elektromotoren, insbesondere in Abhängigkeit von solchen Messdaten, anzusteuern und damit zu aktuieren.

Nachdem der Wafer 2 inspiziert wurde, verfährt der Wafertisch in y-Richtung zurück zur y-Ausgangsposition. Dort wird der Wafer mittels eines Anhebens des Auszugsmittels 60 in z-Richtung von der Tischaufnahme 30 auf die Auszugsaufnahme 70 übernommen, über die z-Erstreckung des Wafertisches erhoben, und anschließend in x-Richtung zurück in ein Waferlager, insbesondere das Waferausgangslager oder ein anderes Waferlager transportiert.

Es sind auch Anwendungen vorgesehen, in denen der Wafer 2 nach der Inspektion mittels des Ausrichtmittels 40 in seine ursprüngliche Drehwinkellage α oder eine beliebige andere, nach Anwendungsfall vorbestimmte, Drehwinkellage ausgerichtet wird, bevor er von der Auszugsaufnahme 70 in einem Waferlager abgelegt oder an eine andere, sich nach dem jeweiligen Anwendungsfall bestimmende, Einrichtung übergeben wird.

### Bezugszeichenliste

- 1: Waferausrichtvorrichtung
- 2: Wafer
- 3: Waferoberfläche
- 4: Kantenfeature (z.B. Notch)

- 20: Wafertisch
- 21: Ausnehmung
- 22: Begrenzung
- 30: Tischaufnahme
- 31: Tischaufnahmeelement

- 40: Ausrichtmittel
- 41: Ausrichtversatzelement
- 42: Ausrichtstütze
- 43: Drehbasis
- 50: Ausrichtaufnahme
- 51: Ausrichtaufnahmeelement
- 53: Ausrichtring
- 54: Ringausnehmung
- 55: Aufnahmeelementausnehmung
- P_{A}: Ausrichtposition
- P_{RA}: Ruheposition

- 60: Auszugsmittel
- 61: Auszugsversatzelement
- 62: vertikale Auszugsstütze
- 63: horizontale Auszugsstütze
- 70: Auszugsaufnahme
- P_{U}: Übergabeposition
- P_{RU}: Ruheposition
- 80: Ausrichtsensoreinrichtung
- 81: Lichtvorhang

- 100: Wafertransportsystem
- T: Tischaufnahmeebene
- X: erste Richtung
- Y: zweite Richtung
- α: Drehwinkellage
- α_{S}: vorbestimmte Drehwinkellage

## Patentansprüche

1. Wafertransportsystem (100) zum Transport eines Wafers (2), insbesondere zu einer Inspektionsposition einer Waferinspektionsanlage, aufweisend:
- eine Waferausrichtvorrichtung (1) zur Ablage eines Wafers (2) in einer vorbestimmten Drehwinkellage (α_{S}), aufweisend:
- einen Wafertisch (20) mit einer Tischaufnahme (30) zur Aufnahme des Wafers (2) in einer Tischaufnahmeebene (T),
- ein Ausrichtmittel (40) mit einer zur Ausrichtung des Wafers (2) auf eine vorbestimmte Drehwinkellage eingerichteten Ausrichtaufnahme (50),
wobei
- wenigstens eines von der Ausrichtaufnahme (50) und der Tischaufnahme (30) eingerichtet ist, durch eine vertikale Relativbewegung gegenüber dem anderen von der Ausrichtaufnahme (50) und der Tischaufnahme (30) den in der Ausrichtaufnahme (50) aufgenommenen Wafer (2) bei einem Queren der Ausrichtaufnahme (50) und der Tischaufnahmeebene (T) auf der Tischaufnahme (30) abzulegen,
und wobei
- der Wafertisch (20) eine Ausnehmung (21) aufweist, durch welche hindurch die Ausrichtaufnahme (50) vertikal verfahrbar ist, und deren Begrenzung (22) wenigstens teilweise als wenigstens ein Tischaufnahmeelement (31) ausgebildet ist, und
- die Ausrichtaufnahme (50) in ihrer Ruheposition (P_{RA}) unterhalb der Tischaufnahmeebene (T) des Wafertisches (20) angeordnet ist,
und
- ein Auszugsmittel (60) mit einer Auszugsaufnahme (70) für den Transport des Wafers (2) von einem Lagerort in einem Waferlager zu der Waferausrichtvorrichtung (1), wobei die Auszugsaufnahme (70) vor einer Übergabe des Wafers (2) in einer Übergabeposition Pu oberhalb der Ausrichtaufnahme (50) angeordnet ist,
- das Auszugsmittel (60) zum Transport des Wafers (2) von einem Lagerort in einem Waferlager zu der Waferausrichtvorrichtung (1) wenigstens mit der Auszugsaufnahme (70) durch die Ausnehmung (21) des Wafertisches (20) hindurch vertikal verfahrbar ist,
wobei
- die Ausrichtaufnahme (50) bei der Aufnahme des Wafers (2) in einer Ausrichtposition (P_{A}) oberhalb der Tischaufnahmeebene (T) des Wafertisches (20) angeordnet ist,
- wenigstens eine von der Ausrichtaufnahme (50) und der Auszugsaufnahme (70) eingerichtet ist, durch eine vertikale Relativbewegung gegenüber der anderen von der Ausrichtaufnahme (50) und der Auszugsaufnahme (70) einen in der Auszugsaufnahme (70) aufgenommenen Wafer (2) bei einer Umkehr der relativen vertikalen Positionen der Ausrichtaufnahme (50) und der Auszugsaufnahme (70) zueinander auf der Ausrichtaufnahme (50) abzulegen, **dadurch gekennzeichnet, dass**
- der Wafertisch (20) dazu eingerichtet ist, einen ausgerichteten Wafer (2) in eine Inspektionsposition einer Waferinspektionsanlage zu transportieren.

2. Wafertransportsystem (100) gemäß Anspruch 1, wobei bei der Ablage des Wafers (2) auf der Tischaufnahme (30) wenigstens ein Tischaufnahmeelement (31) in eine senkrechte Projektion der Waferoberfläche (3) radial eingreift.

3. Wafertransportsystem (100) gemäß einem der vorherigen Ansprüche, zusätzlich aufweisend eine Ausrichtsensoreinrichtung (80) zur Detektion einer Drehwinkellage (α) des Wafers (2) bei Ablage in der Ausrichtaufnahme (50), wobei
diese Ausrichtsensoreinrichtung wenigstens eine Kamera und/oder einen Lichtvorhang (81) zur optischen Detektion von Oberflächen- und/oder Kantenfeatures (4) des Wafers (2) aufweist, und wobei
die Ausrichtaufnahme (50) eingerichtet ist, den Wafer (2) in Abhängigkeit von einem ermittelten Unterschied zwischen der detektierten Drehwinkellage (α) und der vorbestimmten Drehwinkellage (α_{S}) rotatorisch auszurichten.

4. Wafertransportsystem (100) gemäß dem vorherigen Anspruch, wobei
der Wafertisch (20) bei einem Transport des Wafers (2) in Richtung einer Inspektionsposition relativ zu dem Auszugsmittel (60) und zu dem Ausrichtmittel (40) verfahrbar ist, wobei das Auszugsmittel (60) und das Ausrichtmittel (40), insbesondere während des Transports, jeweils unterhalb der Tischaufnahmeebene (T) angeordnet sind.

5. Wafertransportsystem (100) gemäß einem der vorherigen Ansprüche, wobei mittels einer Ausrichtsensoreinrichtung (80) der Waferausrichtvorrichtung (1) eine Relativposition des Wafers (2) zu der Tischaufnahme (30) des Wafertisches (20) ermittelbar ist, wobei
- das Auszugsmittel (60) eingerichtet ist, durch eine translatorische Bewegung in eine erste Richtung (x) nötigenfalls eine von einem vorbestimmten Wert, insbesondere Null, abweichende Relativposition des Wafers (2) in dieser Richtung (x) auszugleichen, und/oder
- der Wafertisch (20) eingerichtet ist, durch eine translatorische Bewegung in eine zweite, zur ersten orthogonale, Richtung (y) nötigenfalls eine von einem vorbestimmten Wert, insbesondere Null, abweichende Position des Wafers (2) in dieser Richtung (y) auszugleichen.

6. Wafertransportsystem (100) gemäß einem der vorherigen Ansprüche, bei welcher
- der Wafertisch (20) in einer ersten Richtung (x) translatorisch festgelegt ist,
- das Auszugsmittel (60) in einer zweiten, zur ersten Richtung orthogonalen, Richtung (y) translatorisch festgelegt ist, und/oder
- das Ausrichtmittel (40) in der ersten Richtung (x) und in der zweiten Richtung (y) translatorisch festgelegt ist.

7. Waferinspektionsanlage mit wenigstens einem, insbesondere zwei Wafertransportsystemen (100) gemäß einem der vorherigen Ansprüche.

8. Verfahren zum Ausrichten eines Wafers (2) auf eine vorbestimmte Drehwinkellage (α_{S}), wobei
- ein Wafertransportsystem (100) nach einem der Ansprüche 1 bis 6 bereitgestellt wird,
- die Ausrichtaufnahme (50) des Ausrichtmittels (40) oberhalb der Tischaufnahmeebene (T) der Tischaufnahme (30) des Wafertisches (20) angeordnet wird,
- der Wafer (2) in die Ausrichtaufnahme (50) aufgenommen wird,
- der Wafer (2) mittels des Ausrichtmittels (40) in der Ausrichtaufnahme (50) rotatorisch auf eine vorbestimmte Drehwinkellage (α_{S}) ausgerichtet wird, wobei das Ausrichten in Abhängigkeit von Messwerten einer Ausrichtsensoreinrichtung (80) erfolgen kann,
- wenigstens eine von der Ausrichtaufnahme (50) und der Tischaufnahme (30) vertikal relativ gegenüber der anderen von der Ausrichtaufnahme (50) und der Tischaufnahme (30) bewegt wird, sodass die Ausrichtaufnahme (50) und die Tischaufnahmeebene (T) einander queren, wobei der Wafer (2) auf der Tischaufnahme (30) abgelegt wird.

9. Verfahren gemäß dem vorherigen Anspruch, wobei
- die Ausrichtaufnahme (50) so weit unter die Tischaufnahmeebene (T) abgesenkt wird, dass der ausgerichtete Wafer (2) aus der Ausrichtaufnahme (50) an die in der Tischaufnahmeebene (T) angeordnete Tischaufnahme (30) übergeben wird, und wobei
bei der Aufnahme des Wafers (2) in die Tischaufnahme (30) wenigstens ein Teil der Waferoberfläche (3) auf wenigstens einem Tischaufnahmeelement (31), insbesondere einem Teil der Begrenzung (22) einer Ausnehmung (21) des Wafertisches (20), abgelegt wird.

10. Verfahren zum Transport eines Wafers (2), insbesondere zu einer Inspektionsposition einer Waferinspektionsanlage, wobei
- ein Wafertransportsystem (100) nach einem der Ansprüche 1 bis 6 bereitgestellt wird,
- der Wafer (2) mittels der Auszugsaufnahme (70) des Auszugsmittels (60) aus einem Waferlager entnommen und zu der Übergabeposition (Pu) oberhalb der Tischaufnahme (30) und der Ausrichtaufnahme (50) verfahren wird,
- eine vertikale Relativposition der Auszugsaufnahme (70) und der Ausrichtaufnahme (50) zueinander in der Art verändert, insbesondere umgekehrt, wird, dass der Wafer (2) oberhalb der Tischaufnahme (30) aus der Auszugsaufnahme (70) in die Ausrichtaufnahme (50) aufgenommen wird, und wobei
- der Wafer (2) gemäß einem Verfahren nach einem der Ansprüche 8 oder 9 ausgerichtet, in der Tischaufnahme (30) aufgenommen und zu wenigstens einer Inspektionsposition der Waferinspektionsanlage verfahren wird.

11. Verfahren gemäß einem der Ansprüche 8 bis 10, wobei
- mittels einer Ausrichtsensoreinrichtung (80) eine Position des aus dem Waferlager entnommenen Wafers (2) auf dem Auszugsmittel (60) bezüglich einer ersten horizontalen Richtung (x) ermittelt wird, und
- in Abhängigkeit von der ermittelten Position des Wafers (2) in dieser Richtung (x) das Auszugsmittel (60) derart translatorisch bewegt wird, dass der Wafer (2) an der durch eine Führung des Wafertisches (20) bezüglich einer zweiten, zur ersten orthogonalen, Richtung (y) vorgegebenen Position in der ersten Richtung (x), insbesondere über das Ausrichtmittel (40) an die Tischaufnahme (30) übergeben wird.

12. Verfahren gemäß einem der Ansprüche 8 bis 11, wobei
- mittels einer Ausrichtsensoreinrichtung (80) eine Position des aus dem Waferlager entnommenen Wafers (2) in der zweiten Richtung (y) auf dem Auszugsmittel (60) ermittelt wird, und
- in Abhängigkeit von der ermittelten Position des Wafers (2) in dieser Richtung (y) der Wafertisch (20) derart translatorisch bewegt wird, dass der Wafer (2) an der, bezüglich der zweiten Richtung (y) ermittelten Position, insbesondere über das Ausrichtmittel (40), an die Tischaufnahme (30) übergeben wird.

## Claims

1. A wafer transport system (100) for transporting a wafer (2), in particular to an inspection position of a wafer inspection installation, including:
- a wafer aligning device (1) for depositing a wafer (2) in a predetermined rotational angular position (α_{S}), including:
- a wafer table (20) comprising a table receptacle (30) for receiving the wafer (2) in a table receptacle plane (T),
- an aligning means (40) comprising an aligning receptacle (50) adapted for aligning the wafer (2) with a predetermined rotational angular position,
wherein
- at least one of the aligning receptacle (50) and the table receptacle (30) is adapted, by a vertical relative movement with respect to the other one of the aligning receptacle (50) and the table receptacle (30), to deposit the wafer (2) received in the aligning receptacle (50) on the table receptacle (30) when the aligning receptacle (50) and the table receptacle plane (T) pass each other,
and wherein
- the wafer table (20) includes a recess (21) through which the aligning receptacle (50) is vertically traversable, and whose boundary (22) is at least partly formed as at least one table receptacle element (31), and
- the aligning receptacle (50) in its resting position (P_{RA}) is arranged below the table receptacle plane (T) of the wafer table (20),
and
- an extraction means (60) comprising an extraction receptacle (70) for the transport of the wafer (2) from a storage place in a wafer store to the wafer aligning device (1), wherein the extraction receptacle (70) is arranged above the aligning receptacle (50) before handing over the wafer (2) in a hand-over position Pu,
- the extraction means (60) is vertically traversable through the recess (21) of the wafer table (20) at least with the extraction receptacle (70) for transporting the wafer (2) from a storage place in a wafer store to the wafer aligning device (1),
wherein
- the aligning receptacle (50) is arranged in an aligning position (P_{A}) above the table receptacle plane (T) of the wafer table (20) when the wafer (2) is received,
- at least one of the aligning receptacle (50) and the extraction receptacle (70) is adapted to deposit a wafer (2) received in the extraction receptacle (70) on the aligning receptacle (50) by a vertical relative movement with respect to the other one of the aligning receptacle (50) and the extraction receptacle (70) on reversal of the relative vertical positions of the aligning receptacle (50) and the extraction receptacle (70) with respect to each other, **characterized in that**
- the wafer table (20) is adapted to transport an aligned wafer (2) into an inspection position of a wafer inspection installation.

2. The wafer transport system (100) according to claim 1, wherein on deposition of the wafer (2) on the table receptacle (30) at least one table receptacle element (31) radially engages into a vertical projection of the wafer surface (3).

3. The wafer transport system (100) according to any of the preceding claims, additionally including
an alignment sensor device (80) for detecting a rotational angular position (α) of the wafer (2) on deposition in the aligning receptacle (50), wherein
this alignment sensor device includes at least one camera and/or a light curtain (81) for the optical detection of surface and/or edge features (4) of the wafer (2),
and wherein
the alignment receptacle (50) is adapted to rotatorily align the wafer (2) in dependence on a determined difference between the detected rotational angular position (α) and the predetermined rotational angular position (αₛ).

4. The wafer transport system (100) according to the preceding claim, wherein
on transport of the wafer (2) in the direction of an inspection position, the wafer table (20) is traversable relative to the extraction means (60) and to the aligning means (40), wherein the extraction means (60) and the aligning means (40), in particular during transport, are each arranged below the table receptacle plane (T).

5. The wafer transport system (100) according to any of the preceding claims, wherein by means of an alignment sensor device (80) of the wafer aligning device (1) a relative position of the wafer (2) relative to the table receptacle (30) of the wafer table (20) can be determined, wherein
- the extraction means (60) is adapted to compensate, if necessary, a relative position of the wafer (2) deviating from a predetermined value, in particular zero, in a direction (x) by a translational movement in this direction (x), and/or
- the wafer table (20) is adapted to compensate, if necessary, a position of the wafer (2) deviating from a predetermined value, in particular zero, in a second direction (y) orthogonal to the first direction by a translational movement in this second direction (y).

6. The wafer transport system (100) according to any of the preceding claims, in which
- the wafer table (20) is translationally fixed in a first direction (x),
- the extraction means (60) is translationally fixed in a second direction (y) orthogonal to the first direction, and/or
- the aligning means (40) is translationally fixed in the first direction (x) and in the second direction (y).

7. A wafer inspection installation comprising at least one, in particular two wafer transport systems (100) according to any of the preceding claims.

8. A method for aligning a wafer (2) with a predetermined rotational angular position (α_{S}), wherein
- a wafer transport system (100) according to any of claims 1 to 6 is provided,
- the aligning receptacle (50) of the aligning means (40) is arranged above the table receptacle plane (T) of the table receptacle (30) of the wafer table (20),
- the wafer (2) is received in the aligning receptacle (50),
- the wafer (2) is rotationally aligned with a predetermined rotational angular position (αₛ) in the aligning receptacle (50) by means of the aligning means (40), wherein the alignment can be effected in dependence on measured values of an alignment sensor device (80),
- at least one of the aligning receptacle (50) and the table receptacle (30) is vertically moved relative to the other one of the aligning receptacle (50) and the table receptacle (30) so that the aligning receptacle (50) and the table receptacle plane (T) cross each other, wherein the wafer (2) is deposited on the table receptacle (30).

9. The method according to the preceding claim, wherein
- the aligning receptacle (50) is lowered below the table receptacle plane (T) to such an extent that the aligned wafer (2) is handed over from the aligning receptacle (50) to the table receptacle (30) arranged in the table receptacle plane (T), and wherein
- on receipt of the wafer (2) in the table receptacle (30) at least part of the wafer surface (3) is deposited on at least one table receptacle element (31), in particular on a part of the boundary (22) of a recess (21) of the wafer table (20).

10. A method for transporting a wafer (2), in particular to an inspection position of a wafer inspection system, wherein
- a wafer transport system (100) according to any of claims 1 to 6 is provided,
- the wafer (2) is removed from a wafer store by means of the extraction receptacle (70) of the extraction means (60) and traversed to the hand-over position (Pu) above the table receptacle (30) and the aligning receptacle (50),
- a vertical relative position of the extraction receptacle (70) and the aligning receptacle (50) relative to each other is changed, in particular reversed in such a way that the wafer (2) is received from the extraction receptacle (70) into the aligning receptacle (50) above the table receptacle (30), and wherein
- the wafer (2) is aligned by a method according to any of claims 8 or 9, received in the table receptacle (30) and traversed to at least one inspection position of the wafer inspection system.

11. The method according to any of claims 8 to 10, wherein
- by means of an alignment sensor device (80) a position of the wafer (2) removed from the wafer store on the extraction means (60) is determined with respect to a first horizontal direction (x), and
- in dependence on the determined position of the wafer (2) in this direction (x) the extraction means (60) is translationally moved in such a way that the wafer (2) is handed over to the table receptacle (30), in particular via the aligning means (40), at the position specified in the first direction (x) by a guidance of the wafer table (20) with respect to a second direction (y) orthogonal to the first direction (x).

12. The method according to any of claims 8 to 11, wherein
- by means of an alignment sensor device (80) a position of the wafer (2) removed from the wafer store on the extraction means (60) is determined in the second direction (y), and
- in dependence on the determined position of the wafer (2) in this direction (y) the wafer table (20) is translationally moved in such a way that the wafer (2) is handed over to the table receptacle (30), in particular via the aligning means (40), at the position determined with respect to the second direction (y).

## Revendications

1. Système de transport de plaquette (100) pour transporter une plaquette (2) (dite « wafer »), en particulier vers une position d'inspection d'une installation d'inspection de plaquette, comprenant :
- un dispositif d'orientation de plaquette (1) pour déposer une plaquette (2) dans une position angulaire de rotation (αₛ) prédéfinie, présentant :
- une table pour plaquette (20) avec un logement de table (30) pour recevoir la plaquette (2) dans un plan de logement de table (T),
- un moyen d'orientation (40) avec un logement d'orientation (50) conçu pour orienter la plaquette (2) selon une position angulaire de rotation prédéfinie,
sachant que
- l'un au moins parmi le logement d'orientation (50) et le logement de table (30) est conçu, par un mouvement relatif vertical par rapport à l'autre parmi le logement d'orientation (50) et le logement de table (30), pour déposer la plaquette (2), logée dans le logement d'orientation (50), sur le logement de table (30) lorsque le logement d'orientation (50) et le plan de logement de table (T) se croisent,
et sachant que
- la table pour plaquette (20) présente un évidement (21) à travers lequel le logement d'orientation (50) peut être déplacé verticalement, et dont la délimitation (22) est réalisée au moins partiellement comme au moins un élément de logement de table (31), et
- dans sa position de repos (P_{RA}), le logement d'orientation (50) est disposé en dessous du plan de logement de table (T) de la table pour plaquette (20), et
- un moyen d'extraction (60) avec un logement d'extraction (70) pour transporter la plaquette (2) d'un emplacement de stockage dans un entrepôt de plaquettes vers le dispositif d'orientation de plaquette (1), le logement d'extraction (70) étant disposé dans une position de transfert Pu au-dessus du logement d'orientation (50), avant de transférer la plaquette (2),
- sachant que le moyen d'extraction (60) pour transporter la plaquette (2) d'un emplacement de stockage dans un entrepôt de plaquettes vers le dispositif d'orientation de plaquette (1) est déplaçable au moins avec le logement d'extraction (70) verticalement à travers l'évidement (21) de la table pour plaquette (20),
sachant que
- le logement d'orientation (50) est disposé dans une position d'orientation (P_{A}) au-dessus du plan de logement de table (T) de la table pour plaquette (20), lorsque la plaquette (2) est logée,
- au moins l'un parmi le logement d'orientation (50) et le logement d'extraction (70) est conçu pour déposer, par un mouvement vertical relatif par rapport à l'autre parmi le logement d'orientation (50) et le logement d'extraction (70), une plaquette (2), logée dans le logement d'extraction (70), sur le logement d'orientation (50) lors d'une inversion des positions verticales relatives du logement d'orientation (50) et du logement d'extraction (70) l'un par rapport à l'autre,
**caractérisé en ce que**
- la table pour plaquette (20) est conçue pour transporter une plaquette orientée (2) jusque dans une position d'inspection d'une installation d'inspection de plaquette.

2. Système de transport de plaquette (100) selon la revendication 1,
dans lequel, lorsque la plaquette (2) est déposée sur le logement de table (30), au moins un élément de logement de table (31) s'engage radialement dans une projection verticale de la surface de plaquette (3).

3. Système de transport de plaquette (100) selon l'une des revendications précédentes, comprenant en outre un dispositif de détection d'orientation (80) pour détecter une position angulaire de rotation (α) de la plaquette (2) lorsqu'elle est déposée dans le logement d'orientation (50), sachant que
ledit dispositif de détection d'orientation comprend au moins une caméra et/ou un rideau lumineux (81) pour la détection optique de caractéristiques de surface et/ou de bord (4) de la plaquette (2), et
le logement d'orientation (50) est conçu pour orienter en rotation la plaquette (2) en fonction d'une différence déterminée entre la position angulaire de rotation (α) détectée et la position angulaire de rotation (α_{S}) prédéfinie.

4. Système de transport de plaquette (100) selon la revendication précédente,
dans lequel, lorsque la plaquette (2) est transportée en direction d'une position d'inspection, la table pour plaquette (20) peut être déplaçable par rapport au moyen d'extraction (60) et au moyen d'orientation (40), sachant que le moyen d'extraction (60) et le moyen d'orientation (40) sont disposés chacun en dessous du plan de table de logement (T), en particulier pendant le transport.

5. Système de transport de plaquette (100) selon l'une des revendications précédentes,
dans lequel un dispositif de détection d'orientation (80) du dispositif d'orientation de plaquette (1) permet de détecter une position relative de la plaquette (2) par rapport au logement de table (30) de la table pour plaquette (20), sachant que
- le moyen d'extraction (60) est conçu pour compenser, si nécessaire, par un mouvement en translation dans une première direction (x), une position relative de la plaquette (2), s'écartant d'une valeur prédéfinie, en particulier nulle, dans cette direction (x), et/ou
- la table pour plaquette (20) est conçue pour compenser, si nécessaire, par un mouvement de translation dans une deuxième direction (y) orthogonale à la première, une position de la plaquette (2), s'écartant d'une valeur prédéfinie, en particulier nulle, dans cette direction (y).

6. Système de transport de plaquette (100) selon l'une des revendications précédentes,
dans lequel
- la table pour plaquette (20) est immobilisée en translation dans une première direction (x),
- le moyen d'extraction (60) est immobilisé en translation dans une deuxième direction (y) orthogonale à la première direction, et/ou
- le moyen d'orientation (40) est immobilisé en translation dans la première direction (x) et dans la deuxième direction (y).

7. Installation d'inspection de plaquette comprenant au moins un, en particulier deux systèmes de transport de plaquette (100) selon l'une des revendications précédentes.

8. Procédé d'orientation d'une plaquette (2) selon une position angulaire de rotation (α_{S}) prédéfinie, dans lequel
- on fournit un système de transport de plaquette (100) selon l'une des revendications 1 à 6,
- le logement d'orientation (50) d'un moyen d'orientation (40) est disposé au-dessus du plan de logement de table (T) du logement de table (30) de la table pour plaquette (20),
- la plaquette (2) est logée dans le logement d'orientation (50),
- à l'aide du moyen d'orientation (40), la plaquette (2) est orientée en rotation dans le logement d'orientation (50) selon une position angulaire de rotation (α_{S}) prédéfinie, l'orientation pouvant se faire en fonction de valeurs mesurées d'un dispositif de détection d'orientation (80),
- l'un au moins parmi le logement d'orientation (50) et le logement de table (30) est déplacé verticalement par rapport à l'autre parmi le logement d'orientation (50) et le logement de table (30), de sorte que le logement d'orientation (50) et le plan de logement de table (T) se croisent, la plaquette (2) étant déposée sur le logement de table (30).

9. Procédé selon la revendication précédente, dans lequel
- le logement d'orientation (50) est abaissé en dessous du plan de logement de table (T) jusqu'à ce que la plaquette orientée (2) soit transférée du logement d'orientation (50) au logement de table (30) disposé dans le plan de logement de table (T), et
lorsque la plaquette (2) est logée dans le logement de table (30), au moins une partie de la surface (3) de la plaquette est déposée sur au moins un élément de logement de table (31), en particulier sur une partie de la délimitation (22) d'un évidement (21) de la table pour plaquette (20).

10. Procédé de transport d'une plaquette (2), en particulier vers une position d'inspection d'une installation d'inspection de plaquette, dans lequel
- on fournit un système de transport de plaquette (100) selon l'une des revendications 1 à 6,
- la plaquette (2) est prélevée d'un entrepôt de plaquettes à l'aide du logement d'extraction (70) du moyen d'extraction (60) et est déplacée vers la position de transfert (Pu) au-dessus du logement de table (30) et du logement d'orientation (50),
- une position relative verticale du logement d'extraction (70) et du logement d'orientation (50) l'un par rapport à l'autre est modifiée, en particulier inversée, de telle sorte que la plaquette (2) est transférée du logement d'extraction (70) au logement d'orientation (50) au-dessus du logement de table (30), et
- la plaquette (2) est orientée par un procédé selon l'une des revendications 8 ou 9, logée dans le logement de table (30) et déplacée vers au moins une position d'inspection de l'installation d'inspection de plaquette.

11. Procédé selon l'une des revendications 8 à 10, dans lequel
- à l'aide d'un dispositif de détection d'orientation (80), on détermine une position de la plaquette (2), prélevée du dépôt de plaquettes, sur le moyen d'extraction (60) par rapport à une première direction horizontale (x), et
- en fonction de la position déterminée de la plaquette (2) dans cette direction (x), le moyen d'extraction (60) est déplacé en translation de telle sorte que la plaquette (2) est transférée au logement de table (30) dans la première direction (x), en particulier par l'intermédiaire du moyen d'orientation (40), au niveau de la position définie par un guidage de la table pour plaquette (20) par rapport à une deuxième direction (y) orthogonale à la première.

12. Procédé selon l'une des revendications 8 à 11, dans lequel
- à l'aide d'un dispositif de détection d'orientation (80), on détermine une position de la plaquette (2), prélevée du dépôt de plaquettes, sur le moyen d'extraction (60) dans la deuxième direction (y), et
- en fonction de la position déterminée de la plaquette (2) dans cette direction (y), la table pour plaquette (20) est déplacée en translation de telle sorte que la plaquette (2) est transférée au logement de table (30) en particulier par l'intermédiaire du moyen d'orientation (40), au niveau de la position déterminée par rapport à la deuxième direction (y).
